# EUROPÄISCHE PATENTANMELDUNG

(11) **EP 0 529 322 A1**
(43) Veröffentlichungstag der Anmeldung: **03.03.1993**
(21) Anmeldenummer: 92112777.5
(22) Anmeldetag: 27.07.1992
(51) Int. Cl.: H01L 29/74

(54) **MOS-gesteuerter Thyristor (MCT)**

(30) Priorität: 16.08.1991 DE 4127033
(71) Anmelder: ASEA BROWN BOVERI AG, CH-5401 Baden (CH)
(72) Erfinder: Bauer, Friedhelm, Dr., CH-5400 Baden (CH)

(57) **Zusammenfassung**

Bei einem MOS-gesteuerten Thyristor MCT, der eine Vielzahl von nebeneinander angeordneten und elektrisch parallelgeschalteten, einzelnen MCT-Zellen (MC) enthält, werden entweder die MCT-Zellen (MC) selbst oder Zellencluster (15) aus wenigen, dichtest-gepackten MCT-Zellen (MC) untereinander durch nichtemittierende Zwischenräume (2) getrennt, deren laterale, lineare Dimensionen mindestens in der gleichen Grössenordnung liegen, wie die lateralen, linearen Dimensionen der MCT-Zellen (MC).

Durch diese Trennung wird die volle Leistungsfähigkeit der einzelnen MCT-Zelle (MC) auch bei grossflächigen Bauelementen mit vielen Zellen realisiert.

## Beschreibung

### TECHNISCHES GEBIET

Die vorliegende Erfindung bezieht sich auf das Gebiet der Leistungselektronik. Sie betrifft einen MOS-gesteuerten Thyristor MCT, umfassend
(a) ein Halbleitersubstrat mit zwei gegenüberliegenden Hauptflächen, von denen die eine einer Anode zugeordnet ist, und die andere einer Kathode zugeordnet ist und eine Kathodenfläche bildet;
(b) innerhalb des Halbleitersubstrats zwischen der Anode und der Kathode eine Schichtenfolge mit einer Emitterschicht von einem ersten Leitfähigkeitstyp, einer ersten Basisschicht von einem zweiten, dem ersten entgegengesetzten Leitfähigkeitstyp, und einer zweiten Basisschicht vom ersten Leitfähigkeitstyp;
(c) innerhalb des Halbleitersubstrats zwischen der Anode und der Kathode eine Vielzahl von nebeneinander angeordneten und parallel geschalteten MCT-Zellen;
(d) innerhalb jeder MCT-Zelle auf der Kathodenseite ein in die zweite Basisschicht eingelassenes Emittergebiet vom zweiten Leitfähigkeitstyp, welches von der Kathodenfläche her durch einen Kathodenkontakt kontaktiert ist; und
(e) innerhalb jeder MCT-Zelle auf der Kathodenseite eine MOS-Struktur, welche einen schaltbaren Kurzschluss zwischen der zweiten Basisschicht und dem Kathodenkontakt bildet;
Ein solcher MCT ist z.B. aus dem Artikel von V. A. K. Temple, IEEE Trans. Electron Devices, Vo. ED-33, S.1609-1618 (1986), bekannt.

### STAND DER TECHNIK

Bei der Anwendung in leistungselektronischen Schaltungen, insbesondere bei drehzahlgesteuerten Motorantrieben, wären wichtige Sytemvereinfachungen durchführbar, wenn bei den verwendeten Leistungshalbleitern die Stromsteuerung, wie man sie derzeit vom GTO her kennt, durch eine Spannungssteuerung ersetzt werden könnte. Dieser Uebergang von Strom- zu Spannungssteuerung ist bei kleineren Leistungen mit dem Ersatz der herkömmlichen Bipolartransistoren durch die neu entwickelten IGBTs (Insulated Gate Bipolar Transistors) bereits vollzogen worden.

Bei grösseren Leistungen, die im wesentlichen den Thyristoren vorbehalten bleiben, sind seit längerer Zeit Bemühungen im Gange, durch die Entwicklung des spannungsgesteuerten MCT (MOS Controlled Thyristor) den GTO in entsprechender Weise abzulösen. Bisher sind diese Bemühungen jedoch nicht sehr erfolgreich verlaufen, weil grossflächige MCTs nach wie vor unter abträglichen inhomogenen Stromverteilungen - insbesondere während der Abschaltphase - leiden.

Dieses Phänomen reduziert bereits für Bauelemente mit Kathodenflächen von nur einem mm² die abschaltbaren Stromdichten auf sehr niedrige Werte von etwa 50 A/cm². Im Gegensatz dazu beobachtet man für Anordnungen von nur wenigen Zellen - ein grossflächiger MCT besteht immer aus einer Vielzahl von einzelnen, kleinen MCT-Zellen; die Kathodenfläche beträgt dann nur etwa 0,01 mm² - exzellente Abschaltstromdichten von mehreren 1000 A/cm².

### DARSTELLUNG DER ERFINDUNG

Aufgabe der Erfindung ist es daher, einen MCT anzugeben, bei dem die hohe Abschaltstromdichte der einzelnen MCT-Zelle auch bei einem Bauelement mit grösserer Kathodenfläche und einer Vielzahl von MCT-Zellen weitgehend erhalten bleibt.

Bei einem MCT der eingangs genannten Art wird die Aufgabe gemäss einer ersten Alternative dadurch gelöst, dass
(f) die einzelnen MCT-Zellen voneinander durch nichtemittierende Zwischenräume getrennt sind; und
(g) die lateralen, linearen Dimensionen der nichtemittierenden Zwischenräume mindestens von der gleichen Grössenordnung sind, wie die lateralen, linearen Dimensionen der einzelnen MCT-Zelle selbst.

Gemäss einer zweiten Alternative wird die Aufgabe dadurch gelöst, dass
(f) alle MCT-Zellen in einer Mehrzahl von Zellenclustern zusammengefasst sind;
(g) jeder Zellencluster aus einigen MCT-Zellen gebildet wird, die untereinander in unmittelbarer Nachbarschaft angeordnet sind;
(h) die Zellencluster voneinander durch nichtemittierende Zwischenräume getrennt sind; und
(i) die lateralen, linearen Dimensionen des nichtemittierenden Zwischenraums mindestens von der gleichen Grössenordnung sind, wie die lateralen, linearen Dimensionen der einzelnen MCT-Zelle selbst.

Der Kern der Erfindung besteht in beiden Fällen darin, entweder die einzelnen MCT-Zellen oder kleine Cluster von mehreren MCT-Zellen durch die Einführung von nichtemittierenden Zwischenräumen so weit voneinander zu entkoppeln, dass die volle Abschaltfähigkeit der einzelnen Zelle auch bei einer Vielzahl von in einem Substrat untergebrachten Zellen erhalten bleibt. Der innere Aufbau der einzelnen MCT-Zelle kann dabei unterschiedliche Formen aufweisen.

Eine erste bevorzugte Ausführungsform der Erfindung zeichnet sich dadurch aus, dass in den Zwischenräumen auf der Kathodenfläche eine verstärkte Oxidschicht abgeschieden ist. Diese Ausführungsform hat den Vorteil einer wesentlich reduzierten Eingangskapazität des Bauelements.

Eine weitere bevorzugte Ausführungsform der Erfindung ist dadurch gekennzeichnet, dass in den Zwischenräumen von der Kathodenfläche her in die zweite Basisschicht ein stark dotiertes, lokalisiertes und frei floatendes Trennungsgebiet vom ersten Leitungstyp eingelassen ist, welches Trennungsgebiet die MCT-Zellen bzw. Zellencluster voneinander trennt. Diese Ausführungsform hat den Vorteil, dass eventuell auftretende Strominhomogenitäten über das Trennungsgebiet ausgeglichen werden können.

Eine dritte bevorzugte Ausführungsform zeichnet sich schliesslich dadurch aus,
(a) in den Zwischenräumen DMOS-Zellen angeordnet sind;
(b) innerhalb jeder DMOS-Zelle auf der Kathodenseite in die zweite Basisschicht ein Kanalgebiet vom zweiten Leitfähigkeitstyp, und in das Kanalgebiet ein Kathodenkurzschlussgebiet vom ersten Leitfähigkeitstyp eingelassen sind, und das Kathodenkurzschlussgebiet von der Kathodenfläche her durch den Kathodenkontakt kontaktiert ist; und
(c) innerhalb jeder DMOS-Zelle auf der Kathodenseite eine MOS-Struktur vorgesehen ist, welche einen schaltbaren Kurzschluss zwischen der zweiten Basisschicht und dem Kathodenkurzschlussgebiet bildet;
Bei dieser Ausführungsform werden in vorteilhafter Weise die Zwischenräume dazu benutzt, um mit den DMOS-Zellen beim Abschalten zusätzlich Löcher aus dem Inneren des Halbleitersubstrats zu extrahieren und somit die Abschaltfähigkeit weiter zu steigern.

Weitere Ausführungsformen ergeben sich aus den Unteransprüchen.

### KURZE BESCHREIBUNG DER ZEICHNUNG

Die Erfindung soll nachfolgend im Zusammenhang mit der Zeichnung anhand von Ausführungsbeispielen näher erläutert werden. Es zeigen
- Fig. 1A: im Ausschnitt eine von der Kathodenseite gesehene grundsätzliche Anordnung von quadratischen MCT-Zellen ohne Zwischenraum (dichteste Packung);
- Fig. 1B: eine Fig. 1A entsprechende Anordnung von MCT-Zellen, die durch Zwischenräume voneinander getrennt sind;
- Fig. 1C: eine zu Fig. 1B vergleichbare Anordnung von streifenförmigen MCT-Zellen, die durch Zwischenräume voneinander getrennt sind;
- Fig. 1D: im Querschnitt ein möglicher innerer Aufbau einer MCT-Zelle, wie sie in den Fig. 1A-C vorkommt;
- Fig. 2: den maximalen Abschaltstrom I_{A} einer einzelnen quadratischen MCT-Zelle mit einer Fläche von 2,25x10⁻⁴ mm² (Kantenlänge: 15 µm x 15 µm) in Abhängigkeit von der Gatespannung V_{g};
- Fig. 3: den maximalen Abschaltstrom in Abhängigkeit von der Gatespannung für dichtest-gepackte Anordnungen von 100, 225 und 2000 gleichartigen, quadratischen MCT-Zellen (Kantenlänge der einzelnen Zelle: 20 µm x 20 µm);
- Fig. 4: den maximalen Abschaltstrom in Abhängigkeit von der Gatespannung für dichtest-gepackte Matrix-Anordnungen von 3 x 3, 5 x 5, 7 x 7, 10 x 10 und 20 x 20 gleichartigen, quadratischen MCT-Zellen (Kantenlänge der einzelnen Zelle: 20 µm x 20 µm) im Vergleich zur Einzelzelle (1 x 1);
- Fig. 5: der aus Fig. 4 abgeleitete Reduktionsfaktor r (als Mass für die Verschlechterung des maximalen Abschaltstromes pro Zelle bei mehreren dichtest-gepackten Zellen relativ zur Einzelzelle) in Abhängigkeit von der Gesamtzahl n _{MC} der MCT-Zellen;
- Fig. 6: den maximalen Abschaltstrom in Abhängigkeit von der Gatespannung für Matrix-Anordnungen von 3 x 3, 6 x 6, 10 x 10, 12 x 12, 15 x 15 und 20 x 20 gleichartigen, quadratischen MCT-Zellen (Kantenlänge der einzelnen Zelle: 15 µm x 15 µm) mit unterschiedlichem Zellenabstand b (15 µm bis 100 µm);
- Fig. 7: der aus Fig. 6 abgeleitete Reduktionsfaktor r in Abhängigkeit vom Zellenabstand b der einzelnen MCT-Zellen;
- Fig. 8A,B: Anordnungen von quadratischen bzw. streifenförmigen MCT-Zellen, die gemäss der Erfindung durch Zwischenräume getrennt sind, deren lineare Abmessungen genauso gross sind, wie die linearen Abmessungen der einzelnen Zelle;
- Fig. 9: Anordnungen von quadratischen MCT-Zellen gemäss der Erfindung mit doppelt so grossen Zwischenräumen;
- Fig. 10A: eine einzelne MCT-Zelle mit einem umgebenden Zwischenraum gemäss der ersten Lösungsalternative der Erfindung;
- Fig. 10B: ein Zellencluster von MCT-Zellen mit einem umgebenden Zwischenraum gemäss der zweiten Lösungsalternative der Erfindung;
- Fig. 10C: ein Zellencluster, welcher gemäss einer bevorzugten Ausführungsform der Erfindung im Zwischenraum von DMOS-Zellen umgeben ist;
- Fig. 11A,B: Draufsicht auf und Querschnitt durch eine Anordnung mit Zellenclustern, die gemäss einer weiteren Ausführungsform der Erfindung in den Zwischenräumen kathodenseitig mit einer verstärkten Oxidschicht bedeckt ist;
- Fig. 12A,B: Draufsicht auf und Querschnitt durch eine Anordnung mit Zellenclustern, die gemäss einer weiteren Ausführungsform der Erfindung in den Zwischenräumen frei floatende, stark dotierte Trennungsgebiete aufweist; und
- Fig. 13: den Querschnitt durch eine DMOS-Zelle gemäss Fig. 10C.

### WEGE ZUR AUSFÜHRUNG DER ERFINDUNG

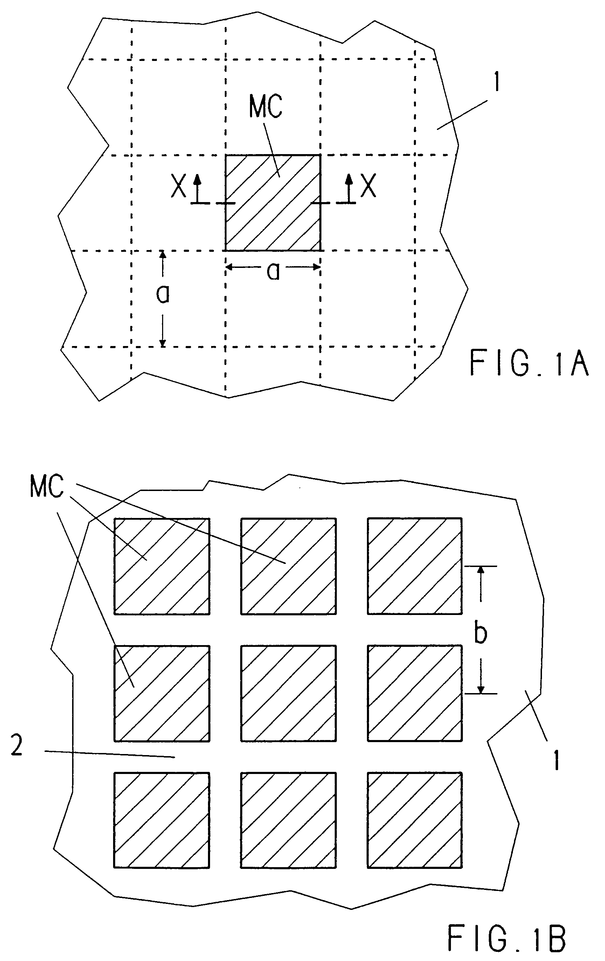

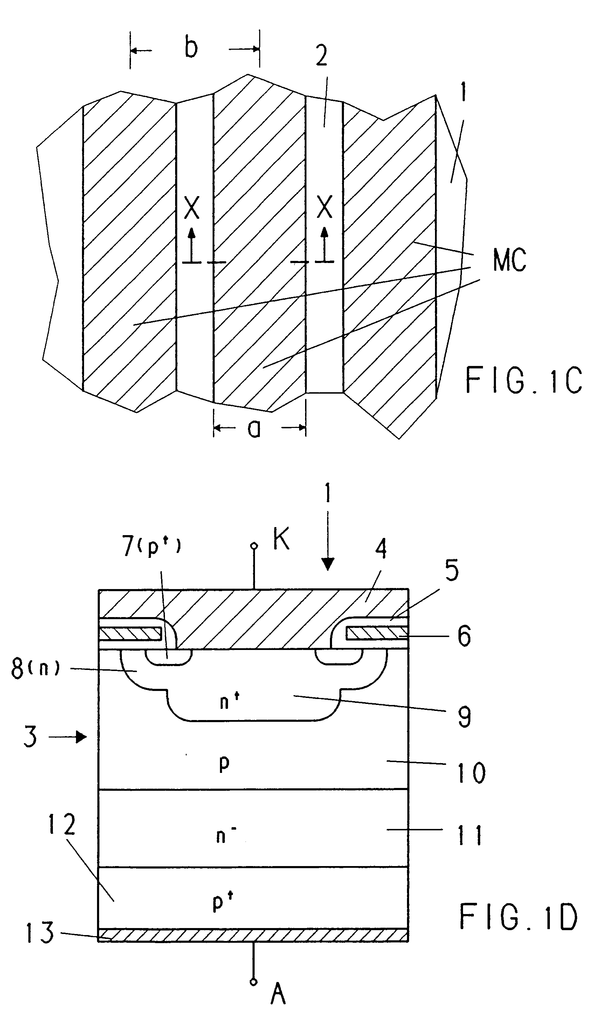

Die Erfindung befasst sich mit der Anordnung von einzelnen, elementaren MCT-Zellen eines MOS-kontrollierten Thyristors MCT innerhalb eines gemeinsamen Halbleitersubstrats. Jede einzelne MCT-Zelle MC (Fig. 1A-C) kann dabei beispielsweise die in Fig. 1D dargestellte und bereits bekannte innere Struktur besitzen, welche einem Querschnitt entlang der Linie X-X in Fig. 1A und C entspricht: In einem Halbleitersubstrat 3 ist dabei zwischen einer Anode A und einer Kathode K eine Schichtenfolge aus einer Emitterschicht 12 (p⁺-dotiert), einer ersten Basisschicht 11 (n⁻-dotiert) und einer zweiten Basisschicht 10 (p-dotiert) angeordnet. In die zweite Basisschicht 10 ist von der Kathodenseite her ein Emittergebiet 9 (n⁺-dotiert) eingelassen, welches auf der Kathodenfläche 1 durch einen Kathodenkontakt 4 kontaktiert wird. Ein entsprechender Anodenkontakt 13 kontaktiert auf der Anodenseite die Emitterschicht 12.

Zum Abschalten sind auf der Kathodenseite MOS-gesteuerte Kurzschlüsse in Form von p-Kanal-MOSFETs vorgesehen, die sich aus der zweiten Basisschicht 10, den Kanalgebieten 8 (n-dotiert), den Kathodenkurzschlussgebieten 7 (p⁺-dotiert) und über den Kanalgebieten 7 isoliert (Gateisolierung 5) angeordneten ersten Gateelektroden 6 zusammensetzen.

Die Funktionsweise dieser Anordnung ist aus dem Stand der Technik bekannt und soll hier deshalb nicht weiter erläutert werden. Weiterhin sei an dieser Stelle darauf hingewiesen, dass die in Fig. 1D wiedergegebene Struktur lediglich eine von mehreren Möglichkeiten darstellt, eine für die Erfindung geeignete MCT-Zelle zu realisieren. Andere geeignete Formen von MCT-Zellen können z.B. eine zu Fig. 1D komplementäre Dotierung aufweisen, oder anstelle des p-Kanal-MOSFETs einen n-Kanal-MOSFET zur Steuerung des Kurzschlusses enthalten.

Ein für grössere Leistungen ausgelegter MCT enthält eine Vielzahl von solchen MCT-Zellen, die im Halbleitersubstrat 3 nebeneinander angeordnet und elektrisch parallelgeschaltet sind. Die laterale Ausdehnung der einzelnen MCT-Zellen MC kann dabei z.B. quadratisch (Fig. 1A und B) oder streifenförmig (Fig. 1C), hexagonal oder von einer anderen Gestalt sein; sie wird durch eine Zellenbreite a charakterisiert. Die Verteilung der MCT-Zellen MC auf der Kathodenfläche 1 hat als charakteristische Grösse einen Zellenabstand b, der von Zellenmitte zu Zellenmitte zwischen benachbarten Zellen gemessen wird.

Grundsätzlich wird von einer dichtest-gepackten Anordnung von MCT-Zellen MC ausgegangen, wie sie in Fig. 1A für quadratische MCT-Zellen wiedergegeben ist. Zellenbreite a und Zellenabstand b sind in diesem Fall gleich gross. Es ist nun aber auch denkbar, die einzelnen MCT-Zellen MC durch nichtemittierende Zwischenräume 2 voneinander zu trennen, wie dies für die Erfindung wesentlich ist und im weiteren Verlauf der Beschreibung noch näher erläutert wird. Der Zellenabstand b ist dann grösser als die Zellenbreite a. Für quadratische Zellen ergibt sich dann die in Fig. 1B dargestellte Konfiguration, für streifenförmige Zellen entsprechend die Konfiguration aus Fig. 1C.

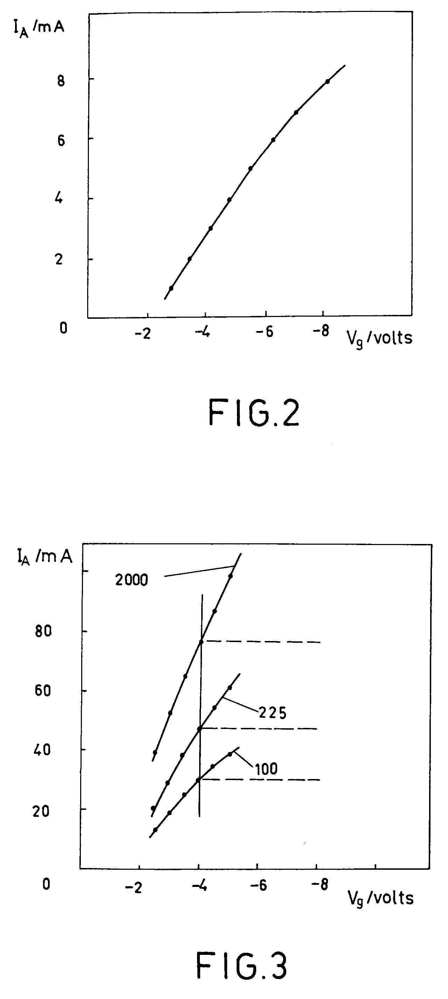

Zur Erklärung der Erfindung ist es zunächst wichtig, die Stärke der MOS-gesteuerten Kurzschlüsse einer einzelnen MCT-Zelle MC zu charakterisieren: Der Betrag des Anodenstromes I_{A}, welcher bei einer vorgegebenen Gatespannung Vg noch kontrolliert werden kann, ist für eine quadratische MCT-Zelle mit den Anmessungen 15 µm x 15 µm (Zellenbreite a=15 µm) in der Fig. 2 dargestellt. Diese Kennlinie kommt einer Geraden recht nahe. Ihre Steigung kann daher als Mass für die Leistungsfähigkeit des MOS-gesteuerten Kurzschlusses betrachtet werden. Im vorliegenden Fall beträgt dieser Zahlenwert etwa 1,2 mA pro Zelle und Volt des Gatespannungssignals. Für eine Zelle mit den Abmessungen 20 µm x 20 µm ergibt sich ein experimenteller Wert von 1,35 mA pro Zelle und Volt. Der etwas höhere Wert für die grössere Zelle ist dabei der grösseren Kanalweite zuzuschreiben.

Für die Realisierung eines leistungsfähigen MCT ist es nun wichtig, zu prüfen, ob der kontrollierbare Anodenstrom I_{A} proportional zur Anzahl der MCT-Zellen ansteigt, falls man einen MCT aufbaut, der aus einer Vielzahl von einzelnen Zellen besteht. Das experimentelle Ergebnis dieser Prüfung ist in Fig. 3 wiedergegeben. Dabei sind Bauelemente mit jeweils 100, 225 und 2000 Zellen (Abmessung der Einzelzelle: 20 µm x 20 µm) untersucht worden. Die I_{A}(V_{g})-Kurven zeigen, dass bereits das kleinste Bauelement (seine Anordnung der Zellen entspricht einer (10 x 10)-Matrix) bei weitem nicht die Leistungsfähigkeit der Einzelzelle erreicht. Obwohl die Fläche des grössten Bauelements (mit 2000 Zellen) zwanzig mal so gross ist, wie die des kleinsten Bauelements (mit 100 Zellen), steigt der kontrollierbare Anodenstrom nur um den Faktor von etwa 3 an.

Aus diesen Ergebnissen lässt sich schlussfolgern, dass die Leistungsfähigkeit (gemeint ist der über die Spannung am MOS-Gate kontrollierbare Anodenstrom) nicht proportional zur Anzahl der Zellen auf der Kathodenfläche ansteigt, sondern bestenfalls mit der Länge der Peripherie (d.h. proportional zur Quadratwurzel aus der Kathodenfläche) wächst, dass also die Leistungsfähigkeit einer Einzelzelle im Allgemeinen nicht auf grössere Flächen skaliert werden kann. Daraus wird auch deutlich, dass ohne besondere Massnahmen und Vorkehrungen ein konkurrenzfähiger, grossflächiger und leistungsfähiger MCT nicht realisiert werden kann.

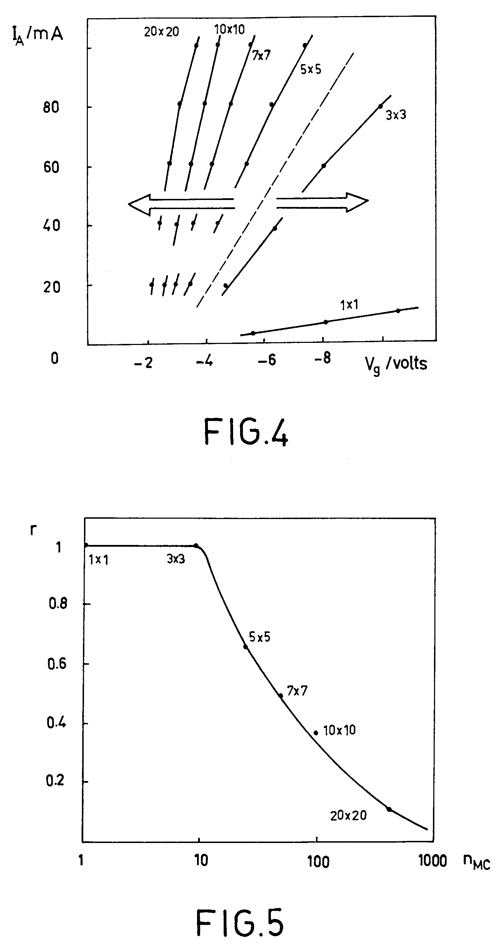

Zur Lösung des Problems führen nun zwei Experimente, deren Ergebnisse in den Figuren 4 bis 7 dargestellt sind und die im Folgenden erläutert werden sollen: In dem ersten Experiment wurden Zellenanordnungen bezüglich des über die Spannung am MOS-Gate kontrollierbaren Anodenstroms charakterisiert. Diese Anordnungen bestanden aus einer Einzelzelle ((1 x 1)-Matrix), sowie Matrixanordnungen von 3 x 3 Zellen, 5 x 5 Zellen, 7 x 7 Zellen, 10 x 10 Zellen und schliesslich 20 x 20 Zellen. In allen Bauelementen (Anordnungen) wurde dabei die gleiche Einzelzelle (20 µm x 20 µm) verwendet. Bei allen Bauelementen handelte es sich um dichtest-gepackte Zellenanordnungen gemäss Fig. 1A.

Die mit diesen Anordnungen kontrollierbaren Anodenströme (normiert auf eine Zelle und ein Gatespannungsinkrement von 1 Volt) sind in Fig. 4 dargestellt. Bei genauer Betrachtung stellt man fest, dass zwischen der Einzelzelle und der (3 x 3)-Zellenmatrix eine lineare Skalierung herrscht, d.h., mit der aus 9 Zellen bestehenden Matrix kann der neunfache Anodenstrom I_{A} - verglichen mit der Einzelzelle - kontrolliert werden. Hingegen setzen bereits bei der (5 x 5)-Matrix zweidimensionale Effekte ein, welche dazu führen, dass mit dieser Struktur das Leistungsniveau der Einzelzelle schon nicht mehr erreicht werden kann.

Zur Beschreibung dieses Leistungsabfalls der Zellen bei Anordnungen mit grösseren Zellenzahlen gegenüber der Einzelzelle ist in Fig. 5 ein Reduktionsfaktor r eingeführt und für die untersuchten Anordnungen aus Fig. 4 in Abhängigkeit von der Zellenzahl n_{MC} dargestellt. Der Zahlenwert von r=1 deutet hierbei das Leistungspotential der Einzelzelle an. Im Fall der (5 x 5)-Anordnung erreicht eine einzelne Zelle (bei Annahme einer homogenen Stromdichteverteilung) nur 66 % (r = 0,66) der Abschaltfähigkeit der Einzelzelle.

Es ist aus Fig. 5 ersichtlich, dass mit wachsender Grösse der Zellenmatrix (wachsendem n_{MC}) die Reduktion der Abschaltfähigkeit schnell zunimmt. Es ist wiederum klar, dass grossflächige Bauelemente (es ist hier an Chipflächen von etwa 1 cm² gedacht) mit dichtester Packung der Zellen ohne eine Lösung des erwähnten Skalierungsproblems nicht denkbar sind.

In dem zweiten Experiment wurde eine andere Variation der geometrischen Anordnung der Zellen vorgenommen. Ausgehend von der schon beschriebenen (20 x 20)-Matrix (Grösse der Einzelzelle: 15 µm x 15 µm) mit dichtester Packung der Zellen wurde der Zellenabstand b (bei der dichtesten Packung 15 µm) bei anderen Anordnungen vergrössert. Zum Vergleich wurden die folgenden Anordnungen herangezogen: (15 x 15)-Matrix mit 20 µm Zellenabstand; (12 x 12)-Matrix mit 25 µm Zellenabstand; (10 x 10)-Matrix mit 30 µm Zellenabstand; (6 x 6)-Matrix mit 50 µm Zellenabstand und schliesslich noch eine (3 x 3)-Matrix mit 100 µm Zellenabstand.

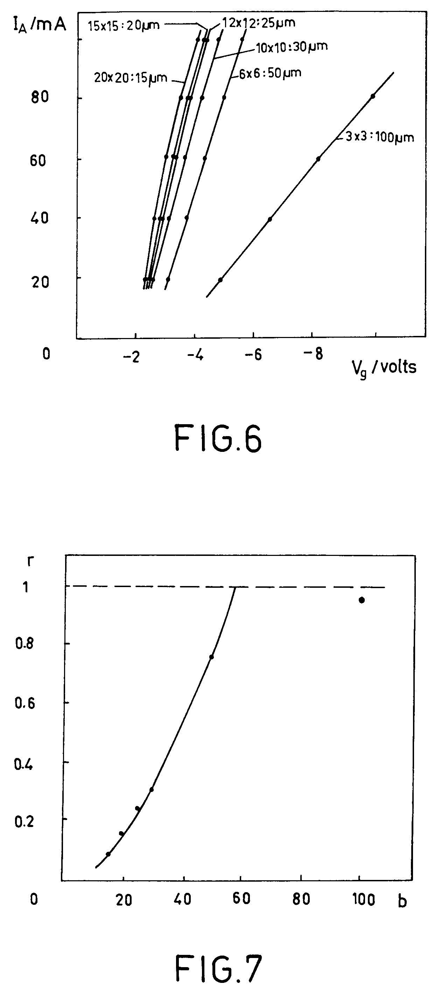

Sämtliche Strukturen wurden wieder bezüglich ihrer Abschaltfähigkeit (normiert auf eine Zelle und 1 Volt Gatespannungsinkrement) mit einer Einzelzelle verglichen. Fig. 6 zeigt (entsprechend Fig. 4 den kontrollierbaren Anodenstrom I_{A} als Funktion der Gatespannung V_{g} für die oben aufgezählten Teststrukturen. Errechnet man auch hier - wie in Fig. 4 und 5 - den Reduktionsfaktor r und trägt diesen über dem Zellenabstand b auf, erhält man die in Fig. 7 dargestellte Kurve.

Bemerkenswert an der in Fig. 7 gezeigten Kurve ist insbesondere, dass die Zellen einer Anordnung mit Zellenabständen b von wenig mehr als 60 bis 70 µm sich wie eine isolierte Einzelzelle verhalten und offensichtlich ihre Nachbarschaft nicht mehr wahrnehmen. Diese Erkenntnis bildet den Ausgangspunkt für die erste Lösungsalternative der vorliegende Erfindung: Es ist falsch, beim MCT die einzelnen MCT-Zellen so dicht wie möglich zu packen; vielmehr ist es eine Voraussetzung, einen Mindestabstand zwischen den Zellen einzuhalten, wenn man auch in grösseren Anordnungen die maximale Abschaltfähigkeit erzielen will.

Wie bereits weiter oben angesprochen worden ist, sind die beschriebenen Experimente zwar an speziellen DMOS-MCT-Strukturen durchgeführt worden, hingegen ist die Relevanz der Erfindung für beliebige MCT-Zellstrukturen - also auch solche vom NMOS-Typ oder solche des komplementären DMOS-Typs - gegeben. Dasselbe gilt auch für alle denkbaren Anodenstrukturen, wie z.B. Anodenkurzschlüsse, zusätzliche Stoppschichten, oder auch für die Ausführung des Randabschlusses.

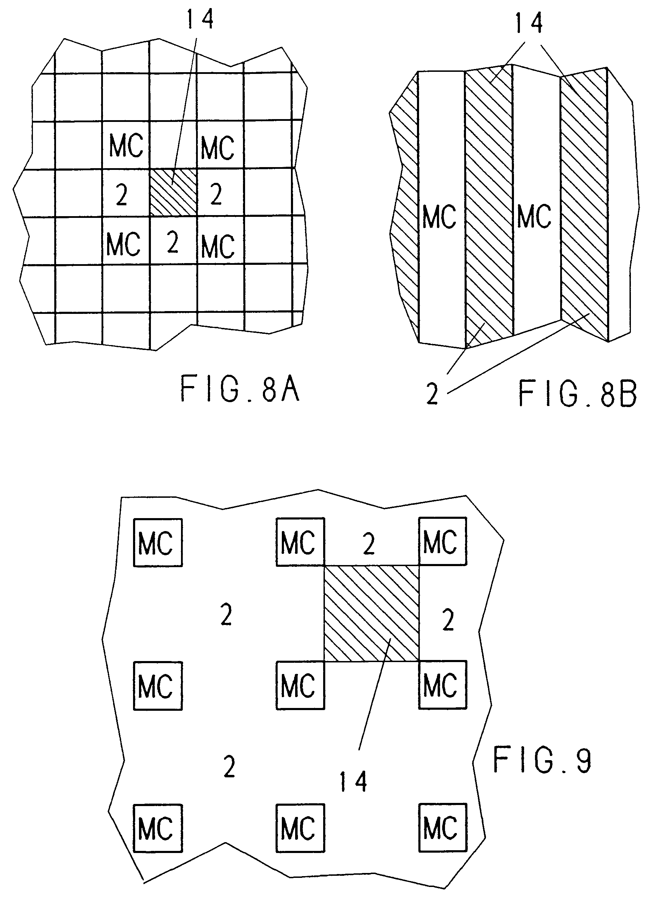

Die erste Lösungsalternative der Erfindung (Fig. 8A und B; Fig. 9) umfasst einzelne, quadratische oder streifenförmige MCT-Zellen MC, die untereinander durch nichtemittierende Zwischenräume 2 mit einer entsprechenden Zwischenfläche 14 zwischen benachbarten Zellen getrennt sind. "Nichtemittierend" bedeutet in diesem Zusammenhang, dass in den Zwischenräumen 2 keine den Emittergebieten 9 der MCT-Zellen vergleichbaren Gebiete vorhanden sind, welche Ladungsträger in die Basisschicht injizieren. Gemäss der Erfindung sind die lateralen, linearen Dimensionen der nichtemittierenden Zwischenräume 2 (im einfachsten Fall die Differenz aus Zellenabstand b und Zellenbreite a) mindestens von der gleichen Grössenordnung, wie die entsprechenden Dimensionen der einzelnen MCT-Zelle MC (Zellenbreite a). Die Zwischenfläche 14 ist dann mindestens genau so gross, wie die Fläche, welche die MCT-Zellen MC beanspruchen. Im Beispiel der Fig. 8A und B sind die linearen Dimensionen von Zelle und Zwischenraum insbesondere gleich. Im Beispiel der Fig. 9 sind die linearen Dimensionen der Zwischenräume 2 doppelt so gross, wie die linearen Dimensionen der Zellen. Die quadratische Zwischenfläche 14 ist in diesem Fall mithin 4-fach so gross wie die Fläche der einzelnen MCT-Zelle MC.

Die Zwischenräume 2 und damit die Zwischenflächen 14 dürfen aber auch noch beliebig grösser sein. Bei sehr grossen Abständen zwischen den MCT-Zellen MC ist allerdings nur noch sehr wenig n⁺-Emitterfläche (der Emittergebiete 9) auf der Kathodenseite vorhanden, so dass mit zum Teil erheblich erhöhten ON-Widerständen zu rechnen ist.

In einer zweiten Lösungsalternative der Erfindung wird daher von dem Ergebnis der vorher geschilderten Experimente Gebrauch gemacht, dass dichtest-gepackte Anordnungen von nur wenigen Zellen in Matrixform, z.B. eine (3 x 3)-Matrix), noch linear skalieren (siehe Fig. 5). Dazu soll hier zunächst der Begriff eines "Clusters" von MCT-Zellen eingeführt werden. Unter einem Zellencluster ist eine "kleine" Anzahl von dichtest-gepackten MCT-Zellen zu verstehen. "Klein" bedeutet dabei mehr als 1, z.B. 1 x 2, 1 x 3, usw., 2 x 2, 2 x 3, 2 x 4 und selbstverständlich auch 3 x 3. Wesentlich ist, dass der Zellencluster so klein ist, dass die Skalierung noch linear erfolgt oder zumindest nicht wesentlich von der Linearität abweicht.

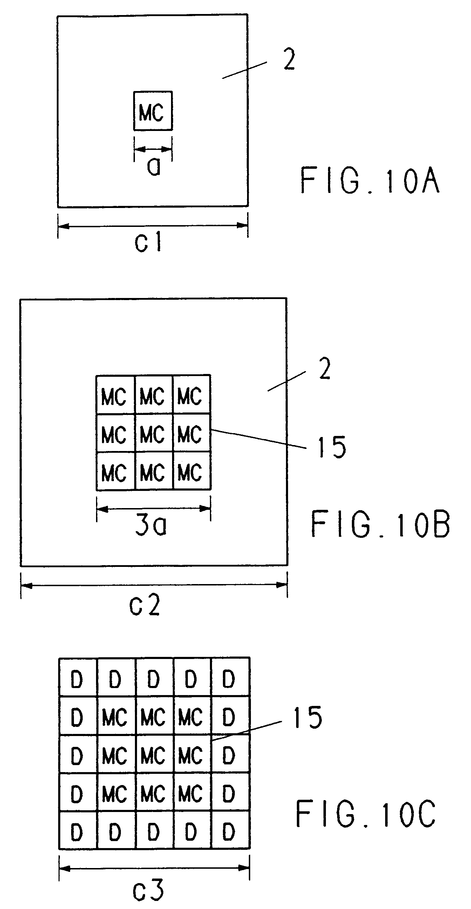

Gemäss der zweiten Lösungsalternative werden nun anstelle der einzelnen MCT-Zellen (Fig. 10A) die oben definierten Zellencluster 15 (Fig. 10B) durch nichtemittierende Zwischenräume 2 getrennt, deren laterale, lineare Dimensionen mindestens von der gleichen Grössenordnung sind, wie die entsprechenden Dimensionen der einzelnen MCT-Zelle MC. Vorzugsweise sollte gemäss Fig. 7 der Zellenabstand b zwischen Zellen verschiedener Cluster wenigstens 60 µm betragen.

Der Vergleich zwischen den Fig. 10A und 10B macht die mit den Zellenclustern erreichte, verbesserte Flächenausnutzung deutlich: In Fig. 10A ist eine quadratische MCT-Zelle MC mit der Zellenbreite a (z.B. 20 µm) von einem nichtemittierenden, quadratischen Zwischenraum 2 mit der Kantenlänge cl (z.B. 100 µm) umgeben. Die lineare Dimension des Zwischenraums 2 beträgt dabei c1-a, gemäss Beispiel also 80 µm. Der Faktor der Flächenausnutzung ist in diesem Fall a²/(c1)², gemäss Beispiel also 1/25 oder 0,04.

In Fig. 10B ist ein Zellencluster 15 in Form einer (3 x 3)-Matrix mit der Clusterbreite 3a (= 60 µm) von einem nichtemittierenden Zwischenraum 2 mit der Kantenlänge c2 (= 140 µm) umgeben. Die lineare Dimension des Zwischenraums 2 beträgt hier ebenfalls 80 µm, die Flächenausnutzung dagegen ist (3a)²/(c2)², d.h. 3600/19600 oder 0,184. Daraus wird deutlich, dass ein Bauelement gemäss der zweiten Lösungsalternative ein erheblich verbessertes Verhältnis von emittierender zu passiver Kathodenfläche aufweist.

Bisher wurde nur gefordert, dass die Zwischenräume 2, welche den Abstand zwischen den einzelnen MCT-Zellen und/oder Zellenclustern herstellen, nicht ihrerseits zur Elektronenemission von der Kathode beitragen. Die Zwischenräume 2 können darüberhinaus aber für andere Zwecke genutzt werden, die mit dem Nichtemittieren in Einklang stehen. So lassen sich insbesondere die linearen Dimensionen der Zwischenräume 2 ohne Einbusse an Leistungsfähigkeit verringern, wenn in den Zwischenräumen 2 Vorrichtungen vorgesehen werden, die eine zusätzliche Extraktion von Löchern beim Abschalten bewirken.

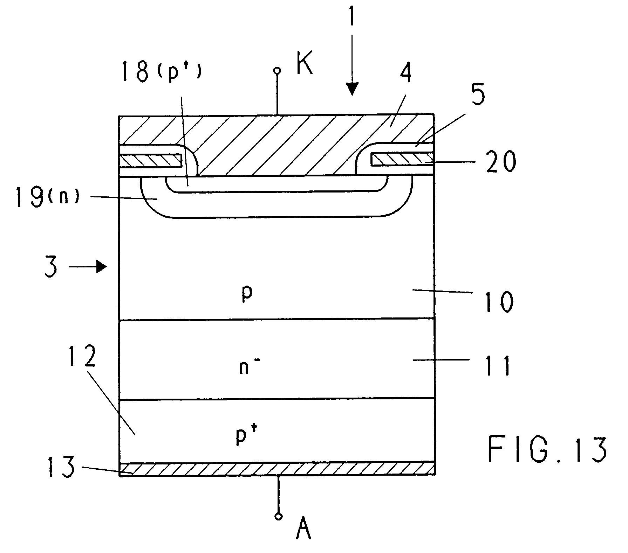

Solche Vorrichtungen sind gemäss einer bevorzugten Ausführungsform der Erfindung sogenannte DMOS-Zellen D (Fig. 10C), welche die einzelne MCT-Zelle oder den Zellencluster 15 umgeben und MOS-gesteuert zur Löcherextraktion eingeschaltet werden können. Der innere Aufbau einer solchen DMOS-Zelle D ist in Fig. 13 wiedergegeben. Neben den bereits aus Fig. 1D bekannten Teilen sind bei dieser Zelle auf der Kathodenseite ein durchgehendes Kanalgebiet 19 (n-dotiert) und ein in dieses Kanalgebiet 19 eingelagertes, durchgehendes Kathodenkurzschlussgebiet 18 (p⁺-dotiert) vorgesehen, die zusammen mit über dem Kanalgebiet 19 isoliert angeordneten zweiten Gateelektroden 20 einen MOS-gesteuerten Kurzschluss zwischen der zweiten Basisschicht 10 und dem Kathodenkurzschlussgebiet bilden.

Im ON-Zustand des Bauelements sind die DMOS-Zellen inaktiv, d.h., der MOS-gesteuerte Kurzschluss ist nicht durchgeschaltet. Die Fünfschicht-Struktur der Zelle ist auf die Funktion des übrigen Bauelements (die MCT-Zellen) ohne Einfluss. Insbesondere eine Emission findet nicht statt. Beim Abschalten dagegen wird der Kurzschluss durchgeschaltet, so dass Löcher aus der zweiten Basisschicht 10 zur Kathode hin extrahiert werden können und die Abschaltfähigkeit insgesamt verbessert wird. Mit derartigen DMOS-Zellen D kann bei einer Anordnung gemäss Fig. 10C bei gleicher Leistungsfähigkeit und Grösse der Zellencluster 15 eine Kantenlänge c3 der Zwischenräume realisiert werden, die mit 100 µm deutlich geringer ist, als in der Anordnung gemäss Fig. 10B, und entsprechend zu einer noch besseren Flächenausnutzung führt.

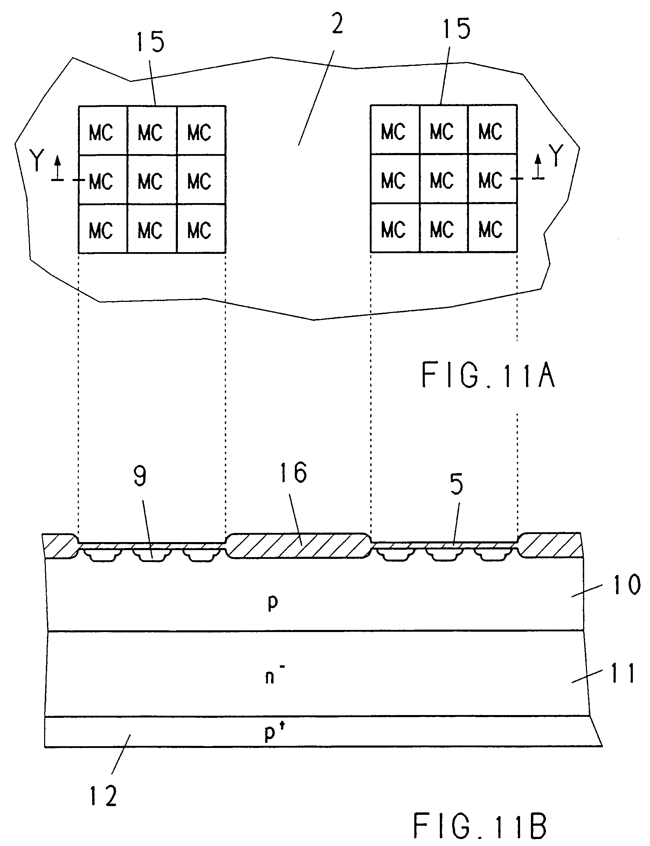

Eine weitere bevorzugte Ausführungsform der Erfindung kann anhand der Fig. 11A und 11B erläutert werden. Fig. 11A zeigt dabei in der Draufsicht die bereits beschriebene Strukturierung der Kathodenfläche mit Zellenclustern 15 und Zwischenräumen 2. Fig. 11B zeigt den inneren Aufbau entlang der Querschnittslinie Y-Y aus Fig. 11A, wobei die Details der einzelnen MCT-Zellen (Kathodenkontaktierung, Gateelektroden etc.) aus Gründen der Uebersichtlichkeit weggelassen sind.

Zur Erläuterung wird noch einmal Bezug genommen auf die die Fig. 10A und 10B. Wird die Kathode in der dort gezeigten Form (MCT-Zelle oder Zellencluster, umgeben von einem nichtemittierenden Zwischenraum) strukturiert, ist es nicht notwendig, die ganze Fläche zwischen den Zellen bzw. Clustern mit einem dünnen Gateoxid (Gateisolierung 5) zu bedecken, da sich MOS-Kanäle, welche das dünne Gateoxid benötigen, nur innerhalb der MCT-Zellen befinden. Es ist deshalb möglich, über den Zwischenräumen 2 auf der Kathodenfläche eine verstärkte Oxidschicht 16 (Fig. 11B) vorzusehen, um auf diese Weise die Eingangskapazität des Bauelements und damit auch die Anforderungen an den Gate-Treiber ganz wesentlich zu reduzieren. Eine Möglichkeit, eine solche im Gegensatz zur dünnen Gateisolierung 5 verstärkte Oxidschicht 16 über den Zwischenräumen 2 zu erzeugen, besteht in der Verwendung eines an sich bekannten LOCOS-Prozesses.

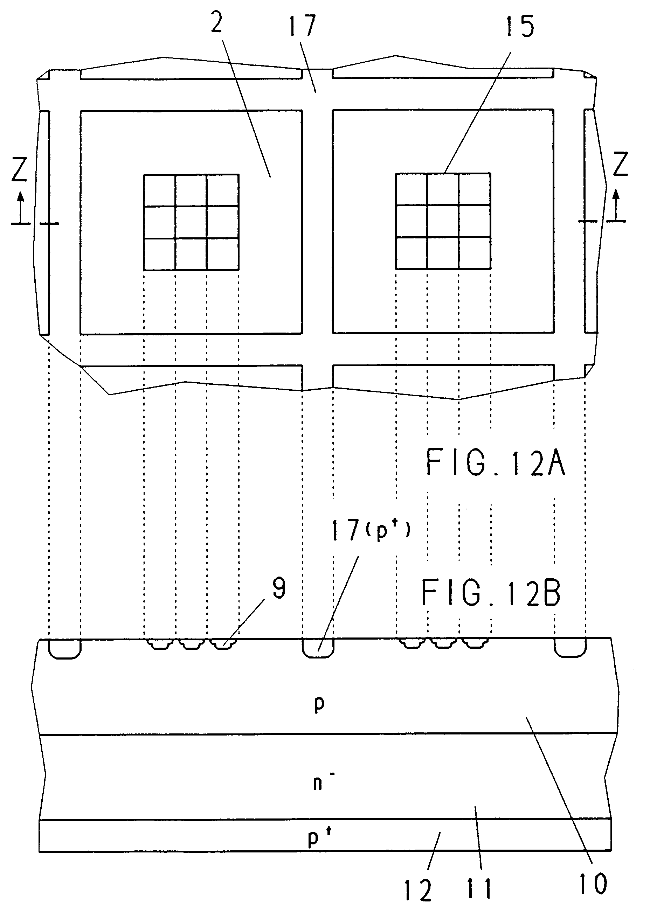

Eine weitere bevorzugte Ausführungsform kann anhand der Fig. 12A und 12B erläutert werden, wobei Fig. 12A diese Ausführungsform in Draufsicht zeigt, während Fig. 12B den Querschnitt entlang der Linie Z-Z in Fig. 12A wiedergibt. Bei dieser Ausführungsform werden die Zwischenräume 2 zwischen den Zellenclustern 15 (bzw. auch den einzelnen MCT-Zellen) auf eine andere Weise zusätzlich genutzt: Innerhalb der in den Zwischenräumen 2 an die Kathodenfläche tretenden, vergleichsweise niedrig dotierten zweiten Basisschicht 10 werden nicht kontaktierte, d.h. frei floatende, stark dotierte Trennungsgebiete 17 (p⁺-dotiert) in Form eine Gitters oder Netzes vorgesehen. Für quadratische Cluster ist diese Struktur in Fig. 12A gezeigt. Für einzelne quadratische Zellen gemäss Fig. 8A bzw. streifenförmige Zellen gemäss Fig. 8B ergeben sich analoge Konfigurationen. Es versteht sich von selbst, dass auch bei dieser Ausführungsform verstärkte Oxidschichten 16 gemäss Fig. 11B vorgesehen werden können.

Der Nutzen der stark dotierten, lokalisierten Trennungsgebiete 17 ist der folgende: Falls es in dem Bauelement zur Ausbildung einer Strominhomogenität oder gar eines Stromfilamentes kommen sollte, ist damit auch eine Erhöhung des lokalen Potentials zwischen Anode A und Kathode K verbunden. Die Entstehung dieses Potentialunterschieds gegenüber den Bereichen mit durchschnittlicher Stromdichte wird durch die Präsenz der niederohmigen Trennungsgebiete 17 behindert, so dass starke Inhomogenitäten ausgeglichen werden.

Insgesamt steht also mit der Erfindung ein MCT zur Verfügung, bei dem die Leistungsfähigkeit der einzelnen Zelle auch auf grösseren Flächen und bei grossen Zellenzahlen in vollem Umfang nutzbar gemacht werden kann.

## Patentansprüche

1. MOS-gesteuerter Thyristor MCT, umfassend
(a) ein Halbleitersubstrat (3) mit zwei gegenüberliegenden Hauptflächen, von denen die eine einer Anode (A) zugeordnet ist, und die andere einer Kathode (K) zugeordnet ist und eine Kathodenfläche (1) bildet;
(b) innerhalb des Halbleitersubstrats (3) zwischen der Anode (A) und der Kathode (K) eine Schichtenfolge mit einer Emitterschicht (12) von einem ersten Leitfähigkeitstyp, einer ersten Basisschicht (11) von einem zweiten, dem ersten entgegengesetzten Leitfähigkeitstyp, und einer zweiten Basisschicht (10) vom ersten Leitfähigkeitstyp;
(c) innerhalb des Halbleitersubstrats (3) zwischen der Anode (A) und der Kathode (K) eine Vielzahl von nebeneinander angeordneten und parallel geschalteten MCT-Zellen (MC);
(d) innerhalb jeder MCT-Zelle (MC) auf der Kathodenseite ein in die zweite Basisschicht (10) eingelassenes Emittergebiet (9) vom zweiten Leitfähigkeitstyp, welches von der Kathodenfläche (1) her durch einen Kathodenkontakt (4) kontaktiert ist; und
(e) innerhalb jeder MCT-Zelle (MC) auf der Kathodenseite eine MOS-Struktur, welche einen schaltbaren Kurzschluss zwischen der zweiten Basisschicht (10) und dem Kathodenkontakt (4) bildet;
dadurch gekennzeichnet, dass
(f) die einzelnen MCT-Zellen (MC) voneinander durch nichtemittierende Zwischenräume (2) getrennt sind; und
(g) die lateralen, linearen Dimensionen der nichtemittierenden Zwischenräume (2) mindestens von der gleichen Grössenordnung sind, wie die lateralen, linearen Dimensionen der einzelnen MCT-Zelle (MC) selbst.

2. MOS-gesteuerter Thyristor MCT nach Anspruch 1, dadurch gekennzeichnet, dass die lateralen, linearen Dimensionen der nichtemittierenden Zwischenräume (2) um ein Mehrfaches grösser sind, als die lateralen, linearen Dimensionen der einzelnen MCT-Zelle (MC) selbst.

3. MOS-gesteuerter Thyristor MCT, umfassend
(a) ein Halbleitersubstrat (3) mit zwei gegenüberliegenden Hauptflächen, von denen die eine einer Anode (A) zugeordnet ist, und die andere einer Kathode (K) zugeordnet ist und eine Kathodenfläche (1) bildet;
(b) innerhalb des Halbleitersubstrats (3) zwischen der Anode (A) und der Kathode (K) eine Schichtenfolge mit einer Emitterschicht (12) von einem ersten Leitfähigkeitstyp, einer ersten Basisschicht (11) von einem zweiten, dem ersten entgegengesetzten Leitfähigkeitstyp, und einer zweiten Basisschicht (10) vom ersten Leitfähigkeitstyp;
(c) innerhalb des Halbleitersubstrats (3) zwischen der Anode (A) und der Kathode (K) eine Vielzahl von nebeneinander angeordneten und parallel geschalteten MCT-Zellen (MC);
(d) innerhalb jeder MCT-Zelle (MC) auf der Kathodenseite ein in die zweite Basisschicht (10) eingelassenes Emittergebiet (9) vom zweiten Leitfähigkeitstyp, welches von der Kathodenfläche (1) her durch einen Kathodenkontakt (4) kontaktiert ist; und
(e) innerhalb jeder MCT-Zelle (MC) auf der Kathodenseite eine MOS-Struktur, welche einen schaltbaren Kurzschluss zwischen der zweiten Basisschicht (10) und dem Kathodenkontakt (4) bildet;
dadurch gekennzeichnet, dass
(f) alle MCT-Zellen (MC) in einer Mehrzahl von Zellenclustern (15) zusammengefasst sind;
(g) jeder Zellencluster (15) aus einigen MCT-Zellen (MC) gebildet wird, die untereinander in unmittelbarer Nachbarschaft angeordnet sind;
(h) die Zellencluster (15) voneinander durch nichtemittierende Zwischenräume (2) getrennt sind; und
(i) die lateralen, linearen Dimensionen des nichtemittierenden Zwischenraums (2) mindestens von der gleichen Grössenordnung sind, wie die lateralen, linearen Dimensionen der einzelnen MCT-Zelle (MC) selbst.

4. MOS-gesteuerter Thyristor MCT nach Anspruch 3, dadurch gekennzeichnet, dass die lateralen, linearen Dimensionen der nichtemittierenden Zwischenräume (2) um ein Mehrfaches grösser sind, als die lateralen, linearen Dimensionen der einzelnen MCT-Zelle (MC) selbst.

5. MOS-gesteuerter Thyristor MCT nach einem der Ansprüche 1-4, dadurch gekennzeichnet, dass in den Zwischenräumen (2) auf der Kathodenfläche (1) eine verstärkte Oxidschicht (16) abgeschieden ist.

6. MOS-gesteuerter Thyristor MCT nach einem der Ansprüche 1-5, dadurch gekennzeichnet, dass in den Zwischenräumen (2) von der Kathodenfläche (1) her in die zweite Basisschicht (10) ein stark dotiertes, lokalisiertes und frei floatendes Trennungsgebiet (17) vom ersten Leitungstyp eingelassen ist, welches Trennungsgebiet (17) die MCT-Zellen (MC) bzw. Zellencluster (15) voneinander trennt.

7. MOS-gesteuerter Thyristor MCT nach einem der Ansprüche 1-4, dadurch gekennzeichnet, dass
(a) in den Zwischenräumen (2) DMOS-Zellen (D) angeordnet sind;
(b) innerhalb jeder DMOS-Zelle (D) auf der Kathodenseite in die zweite Basisschicht (10) ein Kanalgebiet (19) vom zweiten Leitfähigkeitstyp, und in das Kanalgebiet (19) ein Kathodenkurzschlussgebiet (18) vom ersten Leitfähigkeitstyp eingelassen sind, und das Kathodenkurzschlussgebiet (18) von der Kathodenfläche (1) her durch den Kathodenkontakt (4) kontaktiert ist; und
(c) innerhalb jeder DMOS-Zelle (D) auf der Kathodenseite eine MOS-Struktur vorgesehen ist, welche einen schaltbaren Kurzschluss zwischen der zweiten Basisschicht (10) und dem Kathodenkurzschlussgebiet (18) bildet;

8. MOS-gesteuerter Thyristor MCT nach einem der Ansprüche 1-7, dadurch gekennzeichnet, dass
(a) die Emitterschicht (12) p⁺-dotiert, die erste Basisschicht (11) n⁻-dotiert, die zweite Basisschicht (10) p-dotiert und das Emittergebiet (9) n⁺-dotiert ist; und
(b) die MOS-Struktur ein p-Kanal-MOSFET ist.
